# EUROPÄISCHE PATENTANMELDUNG

(11) **EP 1 124 253 A1**
(43) Veröffentlichungstag der Anmeldung: **16.08.2001**
(21) Anmeldenummer: 01102057.5
(22) Anmeldetag: 30.01.2001
(51) Int. Cl.: H01L 21/308, H01L 21/033

(54) **Verfahren zur Grabenätzung in Halbleitermaterial**

(30) Priorität: 02.02.2000 DE 10004394
(71) Anmelder: Infineon Technologies AG, 81669 München (DE)
(72) Erfinder: Engelhardt, Manfred, Dr., 83620 Feldkirchen-Westerham (DE)
(74) Vertreter: Fischer, Volker, Dipl.-Ing.

(57) **Zusammenfassung**

Es wird als Hartmaske eine Maske aus einem gegen den Ätzangriff besonders widerstandsfähigen keramischen Material aufgebracht. Besonders geeignet ist dafür AlN (Aluminiumnitrid). Die hohe Resistenz dieses Materials gegen den Ätzangriff hat den weiteren Vorteil, daß es in der Regel genügt, die Maske als dünne Schicht oder Film aufzubringen. Damit ist auch die Zeit für die Herstellung dieser Masken innerhalb des Halbleiterfertigungsprozesses verringert, während gleichzeitig die Möglichkeit gegeben ist, unter Verwendung dieser Masken sehr tiefe Strukturen zu ätzen.

## Beschreibung

Die vorliegende Erfindung betrifft ein Verfahren zur Erzeugung tiefer Gräben oder Lochstrukturen in Halbleiterbaulementen, bei dem ein Ätzprozeß in Halbleitermaterial unter Verwendung einer Hartmaske durchgeführt wird.

Bei der Herstellung von Halbleiterbauelementen der Mikroelektronik ist es zunehmend wichtig, Löcher oder Gräben in das Halbleitermaterial mit besonders hohen Aspektverhältnissen (Verhältnis der Ätztiefe zum Durchmesser der Struktur) zu ätzen, um z.B. Isolationsgräben oder Speicherkomponenten herzustellen. Mit zunehmender Ätztiefe ist es erforderlich, über eine Hartmaske zu verfügen, die aus einem Material hergestellt wird, das gegen die Ätzchemikalien ausreichend resistent ist. Beim Ätzen von Silizium werden vorzugsweise Masken aus dielektrischem Material wie SiO₂ oder Si₃N₄ oder mehrlagige Schichten aus diesen Materialien verwendet.

Aufgabe der vorliegenden Erfindung ist es, ein verbessertes Verfahren zur Erzeugung von Strukturen mit hohem Aspektverhältnis in Halbleitermaterial anzugeben.

Diese Aufgabe wird mit dem Verfahren mit den Merkmalen des Anspruches 1 gelöst. Ausgestaltungen ergeben sich aus den abhängigen Ansprüchen.

Bei dem erfindungsgemäßen Verfahren wird als Hartmaske eine Maske aus einem keramischen Material aufgebracht. Besonders geeignet ist dafür AlN (Aluminiumnitrid). Die hohe Resistenz dieses Materials gegen den Ätzangriff hat den weiteren Vorteil, daß es in der Regel genügt, die Maske als dünne Schicht oder Film aufzubringen. Damit ist auch die Zeit für die Herstellung dieser Masken innerhalb des Halbleiterfertigungsprozesses verringert, während gleichzeitig die Möglichkeit gegeben ist, unter Verwendung dieser Masken sehr tiefe Strukturen zu ätzen.

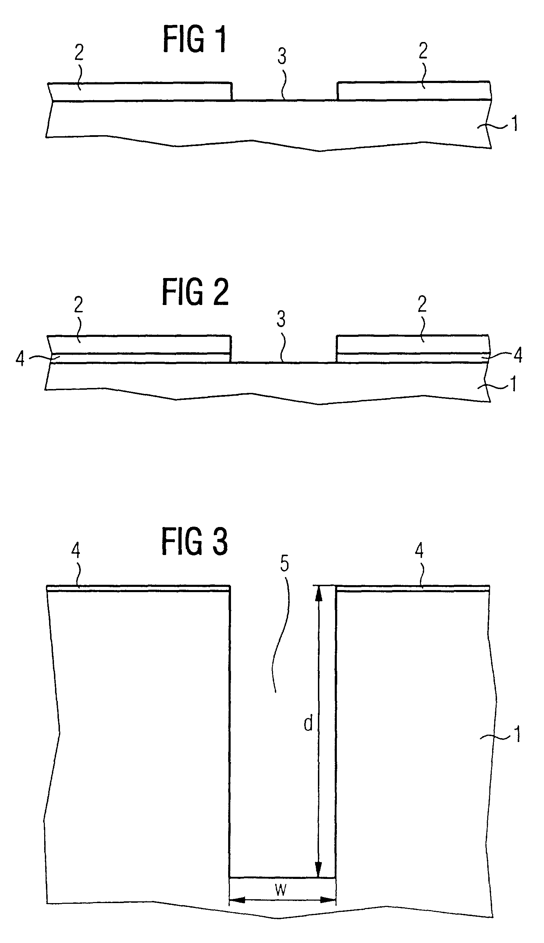

Der Ätzprozeß ist im Prinzip in den Figuren 1 bis 3 dargestellt, die eine zu ätzende Oberseite eines Halbleiterbauelementes im Querschnitt zeigen.

In Figur 1 ist die Oberseite eines Halbleiterkörpers 1 dargestellt, in dem ein Graben oder Loch ausgeätzt werden soll. Die verwendete Maske 2 ist eine Hartmaske aus keramischem Material, das gegen den Ätzangriff besonders resistent ist. Die Maske 2 läßt einen Bereich 3 der Oberseite des Halbleiterkörpers 1 frei, an der der Ätzprozeß Material des Halbleiterkörpers abtragen soll.

In Figur 2 ist ein alternatives Ausführungsbeispiel dargestellt, bei dem auf die zu ätzende Oberseite des Halbleiterkörpers 1 zunächst eine dünne Hilfsschicht 4 aufgebracht wird, bevor die Hartmaske 2 aus keramischem Material hergestellt und strukturiert wird. Die Hilfsschicht 4 verhindert den direkten Kontakt des keramischen Materiales der Maske 2 mit dem Halbleitermaterial des Halbleiterkörpers 1. In den Fällen, in denen der Halbleiterkörper 1 Silizium ist, wird die Hilfsschicht 4 vorzugsweise dadurch hergestellt, daß eine dünne Schicht aus SiO₂ aufgebracht wird oder eine dünne SiO₂-Schicht an der Oberfläche des Siliziumkörpers durch Oxidation des Siliziums hergestellt wird.

In Figur 3 ist ein bevorzugtes Ausführungsbeispiel des Verfahrens dargestellt, bei dem die Maske aus keramischem Material am Ende des Ätzprozesses mit abgetragen ist. Um das zu erreichen, genügt es, die Maske ausreichend dünn aufzubringen. Eine gewisse Abtragung des Materials der Maske während des Ätzprozesses läßt sich nicht vermeiden. Auch bei der erfindungsgemäß verwendeten Hartmaske aus keramischem Material wird immer ein geringer Anteil des Materials der Maske mit abgetragen. Da die Rate, mit der das Material der Maske abgetragen wird, sehr viel niedriger ist als die Ätzrate des Halbleitermateriales des Halbleiterkörpers 1, kann so ein sehr tiefer Graben 5 (Figur 3) in den Halbleiterkörper 1 geätzt werden, während die sehr dünne Hartmaske allmählich abgetragen wird, aber währenddessen verhindert, daß in den seitlich zu dem zu ätzenden Graben vorhandenen Bereichen des Halbleiterkörpers 1 ebenfalls Material des Halbleiterkörpers weggeätzt wird. In Figur 3 ist auch erkennbar, daß mit dem erfindungsgemäßen Verfahren sehr hohe Aspektverhältnisse erzielt werden können, bei denen die Tiefe d des Grabens oder Loches sehr viel größer ist als die seitliche Abmessung w. In Figur 3 ist das Ausführungsbeispiel mit Hilfsschicht 4 dargestellt; diese Hilfsschicht 4 kann aber auch weggelassen sein. Falls nach Beendigung des Ätzprozesses Reste der Maske 2 auf der Oberseite des Halbleiterkörpers 1 übrig sind, werden sie vorzugsweise naßchemisch entfernt. Es schließt sich je nach Bedarf eine Reinigung der Oberseite des Halbleiterkörpers an.

## Patentansprüche

1. Verfahren zur Erzeugung tiefer Gräben oder Lochstrukturen in Halbleiterbauelementen,
bei dem ein Ätzprozeß in Halbleitermaterial unter Verwendung einer Hartmaske (2) durchgeführt wird, die einen zu ätzenden Bereich (3) frei läßt,
**dadurch gekennzeichnet**, daß
als Hartmaske (2) ein keramisches Material aufgebracht wird.

2. Verfahren nach Anspruch 1,
bei dem als keramisches Material AlN verwendet wird.

3. Verfahren nach Anspruch 1 oder 2,
bei dem in Silizium geätzt wird und zwischen dem Silizium und der Hartmaske eine Hilfsschicht (4) aus SiO₂ hergestellt wird.

4. Verfahren nach einem der Ansprüche 1 bis 3,
bei dem die Hartmaske so dünn hergestellt wird, daß sie im Verlauf des Ätzprozesses abgetragen wird.
